# EUROPÄISCHE PATENTSCHRIFT

(11) **EP 0 828 412 B1**
(45) Veröffentlichungstag und Bekanntmachung des Hinweises auf die Patenterteilung: **16.05.2001**
(21) Anmeldenummer: 97202641.3
(22) Anmeldetag: 28.08.1997
(51) Int. Cl.: H05K 9/00

(54) **HF-Modul, z.B. Tuner**
HF-Module, e.g.Tuner
Module haute fréquence, par exemple syntoniseur

(30) Priorität: 06.09.1996 DE 19636181
(43) Veröffentlichungstag der Anmeldung: 11.03.1998
(73) Patentinhaber: Philips Corporate Intellectual Property GmbH, 52064 Aachen (DE); Koninklijke Philips Electronics N.V., 5621 BA Eindhoven (NL)
(72) Erfinder: Lange, Joachim, Röntgenstrasse 24, 22335 Hamburg (DE); Matuschik, Peter, Röntgenstrasse 24, 22335 Hamburg (DE); Duran, Hugo, Röntgenstrasse 24, 22335 Hamburg (DE)
(74) Vertreter: Schmalz, Günther, Dipl.-Ing.

(56) Entgegenhaltungen:
- US-A- 4 841 414
- US-A- 5 434 747

## Beschreibung

Die Erfindung bezieht sich auf ein HF-Modul, z.B. einen Tuner, mit einem Gehäuse und mit einer im Gehäuse angebrachten, elektrische Bauelemente tragenden Leiterplatte, wobei das Gehäuse wannenförmig ausgebildet und mit einem Deckel verschlossen ist.

Es sind Gehäuse für derartige Tuner bekannt, wobei jedes Gehäuse zusammen mit Trennwänden für eine vom Gehäuse aufgenommene Leiterplatte aus einem Stück gefertigt ist. Ein solches Gehäuse wird durch zwei Deckel verschlossen. Bei einem derartigen Gehäuse werden die Massepunkte für die Leiterplatte an den mit den Gehäusewänden vorgefertigten Trennwänden hergestellt. Die Lage der Massepunkte ist somit auf den Bereich der Trennwände beschränkt. Das gleiche gilt für eine andere bekannte Bauweise für derartige Gehäuse, bei denen jedes Gehäuse aus einem Rahmen, aus je einem besonderen Einsatz mit Trennwänden für die Leiterplatte und aus zwei Deckeln besteht. Insgesamt werden für ein derartiges bekanntes Gehäuse somit vier einzelne Teile benötigt.

Derzeit müssen immer mehr Bauelemente auf einer Leiterplatte untergebracht werden, und zwar bei gleicher zur Verfügung stehender Fläche. Wenn derartige komplexe Schaltungen auch noch HF-tauglich sein sollen, so gibt es zusätzliche Probleme, z.B. hinsichtlich der Strahlung, der Entkopplung, des Gleichlaufes usw., da mit den bekannten Bauarten ein zuverlässiger und wirkungsvoller Masseanschluss nicht mehr gewährleistet werden kann.

Durch die DE 35 35 923 A1 ist ein substrathaltender Aufbau für eine mehrlagige bedruckte Schaltungsanordnung bekannt geworden, wobei eine Metallplatte zwischen zwei Substraten gedruckter Schaltungen angeordnet ist. Die Metallplatte besitzt zungenartige Segmente, die derart gebogen sind, dass sie durch in den Schaltungssubstraten ausgebildete Löcher hindurchgeführt werden können, so dass Leiterbahnen auf den jeweils außen liegenden Oberflächen der Schaltungssubstrate an der Metallplatte geerdet werden können. Außerdem ist die Metallplatte im äußeren Randbereich über Verbindungssegmente mit einem Chassis in federnd nachgiebiger Weise verbunden.

Die Schrift US-A-5,434,747 zeigt ein Gehäuse, bei dem leitende Ständerteile und Kontaktstifte ausschließlich linienförmig an den Kanten des Gehäuses angeordnet sind, wobei die Ständerteile hauptsächlich als Halterung für eine Leiterplatte dienen. Die Massekontaktierung wird über die Kontaktstifte der Ständerteile vorgenommen.

Der Erfindung liegt die Aufgabe zugrunde, ein HF-Modul der eingangs genannten Art im Aufbau zu vereinfachen und hinsichtlich einer optimalen Platzausnutzung der Leiterplatte zu verbessern.

Diese Aufgabe wird gemäß der Erfindung dadurch gelöst,
- dass eine Leiterplatte in einem wannenförmigen Gehäuse befestigt ist und
- dass ein elektrisch leitender, sich flächenhaft zu der Leiterplatte erstreckender Einsatz vorgesehen ist, der an den den Massepunkten der Leiterplatte entsprechenden Stellen Kontaktstifte aufweist und über diese Kontaktstifte mit den Massepunkten der Leiterplatte verbunden ist, wobei wenigstens ein Kontaktstift des leitenden Einsatzes nicht an den Kanten des Gehäuses angeordnet ist.

Mit einer derartigen Bauweise ist man nicht mehr, wie bisher, an feste Massepunkte auf der Leiterplatte gebunden, vielmehr kann zunächst die Leiterplatte hinsichtlich der Platzausnutzung optimal aufgebaut werden, wobei die Massepunkte an beliebigen Stellen der Leiterplatte liegen können. Sodann wird der Einsatz hergestellt, wobei die Kontaktstifte an den den Massepunkten entsprechenden Stellen des Einsatzes angeordnet werden, so dass beim Einsetzen des Einsatzes in die Leiterplatte die Kontaktstifte mit den Massepunkten in Berührung geraten und verlötet werden können. Mit einer derartigen Bauweise ist man hinsichtlich der Lage der Massepunkte nunmehr völlig frei. Die Trennwände mit den bisher an deren Unterkanten vorgesehenen Massepunkten können entfallen. Der über die Kontaktstifte mit den Massepunkten der Leiterplatte verbundene Einsatz ist außerdem mit dem wannenförmigen Gehäuse elektrisch leitend verbunden. Ein derartiger Einsatz kann auf einfache Weise hergestellt werden. Durch Wegfall der bisher erforderlichen Trennwände kann sehr einfach ein flacher oder breiter Tuner realisiert werden. Nach dem Verlöten des Einsatzes sind alle Erdungs- bzw. Massepunkte miteinander verbunden. Darüber hinaus ist der Einsatz auch mit dem Gehäuse verbunden. Ein derartiger mechanischer Aufbau ermöglicht die Verwendung von gedruckten Spulen, so daß weniger Platz auf der Leiterplatte erforderlich ist. Ferner ergibt sich eine Platzersparnis dadurch, daß weniger Abblockkondensatoren erforderlich sind. Schließlich können die Werkzeugkosten durch eine einfachere Mechanik erniedrigt werden. Insgesamt ergibt sich durch die bessere und wirkungsvollere Masseverbindung der Massepunkte eine Verbesserung hinsichtlich der Strahlung, Entkopplung, des Gleichlaufes usw..

In Ausgestaltung der Erfindung ist vorgesehen, daß die Kontaktstifte an den Enden stufig verjüngt ausgebildet sind. Dadurch ergeben sich Anschläge, so daß der Einsatz leicht aufgesetzt und verlötet werden kann.

Ein einfacher Aufbau ergibt sich dadurch, daß der Einsatz in Ausgestaltung der Erfindung einteilig mit den Kontaktstiften aufgebaut ist.

Ein einfacher Aufbau ergibt sich ferner dadurch, daß der Einsatz in weiterer Ausgetaltung der Erfindung als Masseplatte ausgebildet ist und daß die Kontaktstifte auf der Masseplatte durch Ausstanzen und rechtwinkliges Abknicken gebildet sind.

In weiterer Ausgestaltung der Erfindung ist vorgesehen, daß die Kontaktstifte an dem Einsatz auch durch Löten befestigt werden können.

Eine weitere Ausgestaltung der Erfindung besteht darin, daß mindestens ein Teil der Kontaktstifte so lang ausgebildet ist, daß diese in entsprechende Öffnungen des Deckels eingreifen und dort durch Klemmen oder Verlöten befestigt sind. Damit ist eine optimale Masseverbindung zwischen dem Gehäuse (Rahmen), dem Einsatz, der Leiterplatte und dem Deckel sichergestellt, wodurch eine sehr gute HF-Abschirmung gewährleistet ist.

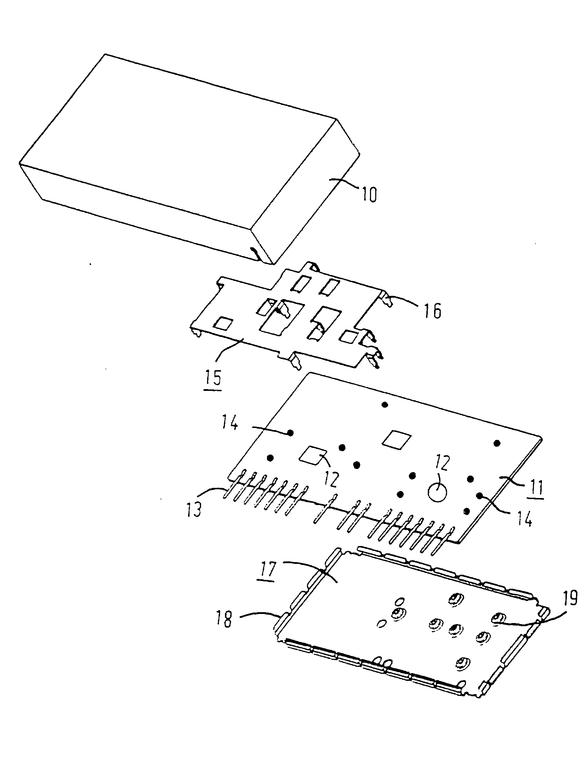

In der Zeichnung ist in der Figur ein Ausführungsbeispiel des Gegenstandes gemäß der Erfindung schematisch und perspektivisch dargestellt. Die Figur zeigt in einer auseinandergezogenen Darstellung einen Tuner mit einem wannenförmigen Gehäuse, einem Einsatz, einer Leiterplatte und einem Deckel.

Das wannenförmige Gehäuse 10 ist z.B. aus einem einteiligen Blechteil gestanzt und durch Knicken in die wannenförmige Form gebracht. Zusätzlich kann eine Verlötung an den aneinanderstoßenden Kanten erfolgen. In dem Gehäuse ist eine Leiterplatte 11 befestigt, die mit schematisch angedeuteten Bauelementen 12 bestückt ist. Mit 13 sind Anschlußstifte bezeichnet. Die Leiterplatte 11 besitzt Massepunkte 14, die mit Bohrungen versehen sind. Mit 15 ist ein metallischer Einsatz bezeichnet, der mit rechtwinklig abgebogenen Kontaktstiften 16 versehen ist. Die Lage dieser Kontaktstifte 16 richtet sich nach der Lage der auf der Leiterplatte 11 angebrachten Massepunkte 14. Die Enden der Kontaktstifte 16 greifen im zusammengebauten Zustand in die Bohrungen bzw. Massepunkte 14 der Leiterplatte 11 ein und sind mit diesen verlötet. Die mit dem Einsatz 15 verlötete Leiterplatte 11 wird nach Fertigstellung in das wannenförmige Gehäuse 10 eingesetzt und dort befestigt. Danach wird das Gehäuse 10 durch einen Deckel 17 verschlossen, der mit federnden Laschen 18 versehen ist. Wie aus der Figur zu ersehen ist, können die Massepunkte 14 an beliebigen Stellen der Leiterplatte 11 vorgesehen sein, wo entsprechender Platz vorhanden ist.

Ein Teil der Kontaktstifte 16 kann so lang ausgebildet sein, daß diese in entsprechende Öffnungen 19 des Deckels 17 eingreifen. Dies ergibt eine optimale Masseverbindung zwischen dem Gehäuse (Rahmen) 10, dem Einsatz 15, der Leiterplatte 11 und dem Deckel 17 und damit eine sehr gute Abschirmung.

## Patentansprüche

1. HF-Modul, z.B. Tuner, mit einem Gehäuse (10) und mit einer im Gehäuse (10) angebrachten, elektrische Bauelemente (12) tragenden Leiterplatte (11), wobei das Gehäuse (10) wannenförmig ausgebildet und mit einem Deckel (17) verschlossen ist, dadurch gekennzeichnet, daß
- die Leiterplatte (11) im wannenförmigen Gehäuse (10) befestigt ist und
- daß ein elektrisch leitender, sich flächenhaft zu der Leiterplatte erstreckender Einsatz vorgesehen ist, der an den den Massepunkten (14) der Leiterplatte (11) entsprechenden Stellen Kontaktstifte (16) aufweist und über diese Kontaktstifte (16) mit den Massepunkten (14) der Leiterplatte (11) verbunden ist, wobei wenigstens ein Kontaktstift des leitenden Einsatzes (15) nicht an den Kanten des Gehäuses angeordnet ist.

2. HF-Modul nach Anspruch 1, dadurch gekennzeichnet, daß die Kontaktstifte (16) an den Enden stufig verjüngt ausgebildet sind.

3. HF-Modul nach Anspruch 1 oder 2, dadurch gekennzeichnet, daß der Einsatz (15) einteilig mit den Kontaktsiften (16) ausgebildet ist.

4. HF-Modul nach Anspruch 3 dadurch gekennzeichnet, daß der Einsatz (15) als Masseplatte ausgebildet ist und daß die Kontaktstifte (16) aus der Masseplatte durch Ausstanzen und rechtwinkliges Abknicken gebildet sind.

5. HF-Modul nach Anspruch 1, dadurch gekennzeichnet, daß die Kontaktstifte an dem Einsatz durch Löten befestigt sind.

6. HF-Modul nach einem der Ansprüche 1 bis 5, dadurch gekennzeichnet, daß mindestens ein Teil der Kontaktstifte (16) so lang ausgebildet ist, daß diese (16) in entsprechende Öffnungen (19) des Deckels (17) eingreifen und dort durch Klemmen oder Verlöten befestigt sind.

## Claims

1. An HF module, for example a tuner, having a housing (10) and having a printed circuit board (11) arranged in the housing (10) and carrying electrical components (12), the housing (10) being trough-shaped and being closed with a lid (17), characterized in that
- the printed circuit board (11) is mounted in the trough-shaped housing (10), and
- an electrically conductive insert is provided, which insert has a surface overlying the printed circuit board and has contact pins (16) at locations corresponding to the grounding points (14) of the printed circuit board (11) and is connected to the grounding points (14) of the printed circuit board (11) via these contact pins (16), at least one contact pin of the conductive insert (15) not being arranged at the edges of the housing.

2. An HF module as claimed in Claim 1, characterized in that the contact pins (16) are tapered stepwise at their ends.

3. An HF module as claimed in Claim 1 or 2, characterized in that the insert (15) is formed integrally with the contact pins (16).

4. An HF module as claimed in Claim 3, characterized in that the insert (15) is formed as a ground plate, and in that the contact pins (16) are formed from the ground plate by punching out and bending at right angles.

5. An HF module as claimed in Claim 1, characterized in that the contact pins are secured to the insert by soldering.

6. An HF module as claimed in any one of the Claims 1 to 5, characterized in that at least some of the contact pins (16) are so long that they (16) engage in corresponding openings (19) of the lid (17) and are secured therein by clamping or soldering.

## Revendications

1. Module haute fréquence, par exemple un syntoniseur, avec un boîtier (10) et avec une carte à circuits imprimés (11) logée dans le boîtier (10) et portant des éléments électriques (12), le boîtier (10) étant conçu en forme de cuvette et fermé par un couvercle (17),
caractérisé en ce
- que la carte à circuits imprimés (11) est fixée dans un boîtier en forme de cuvette (10) et
- qu'il est prévu un insert électriquement conducteur s'étendant en surface sur la carte à circuits imprimés qui présente des broches de contact (16) aux endroits correspondant aux points de mise à la masse (14) de la carte à circuits imprimés (11) et est relié par l'intermédiaire de ces broches de contact (16) avec les points de mise à la masse (14) de la carte à circuits imprimés (11), au moins une broche de contact de l'insert conducteur (15) n'étant pas disposée contre les bords du boîtier.

2. Module HF selon la revendication 1, caractérisé en ce que les broches de contact (16) sont graduellement effilées vers les extrémités.

3. Module HF selon l'une des revendications 1 ou 2, caractérisé en ce que l'insert (15) est conçu en une seule pièce avec les broches de contact (16).

4. Module HF selon la revendication 3, caractérisé en ce que l'insert (15) est conçu comme une plaque de mise à la terre et que les broches de contact (16) sont formées à partir de la plaque de mise à la masse par matriçage et flambage en angle droit.

5. Module HF selon la revendication 1, caractérisé en ce que les broches de contact sont fixées à l'insert par brasage.

6. Module HF selon l'une des revendications 1 à 5, caractérisé en ce qu'au moins une partie des broches de contact (16) est de conception si longue que celles-ci (16) pénètrent dans les ouvertures correspondantes (19) du couvercle (17) et y sont fixées par blocage ou brasage.
